# EUROPEAN PATENT APPLICATION

(11) **EP 2 629 594 A1**
(43) Date of publication of application: **21.08.2013**
(21) Application number: 12155274.9
(22) Date of filing: 14.02.2012
(51) Int. Cl.: H05K 7/20

(54) **Electronic apparatus**

(71) Applicant: ABB Oy, 00380 Helsinki (FI)
(72) Inventor: Smalén, Matti, 00380 Helsinki (FI); Koivuluoma, Timo, 00380 Helsinki (FI); Kauhanen, Matti, 00380 Helsinki (FI)
(74) Representative: Holmström, Stefan Mikael

(57) **Abstract**

The invention relates to an electronic apparatus. In order to provide an electronic apparatus with a more reliable structure, the apparatus comprises an extruded metallic frame (1) with walls (2, 3, 4, 5) which are integrated parts of the extruded metallic frame (1), at least one extruded flow channel in at least one of the walls (2, 3, 4, 5) for passing a cooling fluid within the respective wall, an inlet arranged outside the electronic apparatus and an outlet arranged outside the electronic apparatus for providing a flow path via the at least one extruded flow channel, and detachable covers which are attached to the walls (2, 3, 4, 5) for sealing off at least one electric component space from an outside of the electronic apparatus.

## Description

### BACKGROUND OF THE INVENTION

### FIELD OF THE INVENTION

This invention relates to an electronic, apparatus and more particularly to an electronic apparatus comprising a novel frame structure.

### DESCRIPTION OF PRIOR ART

Previously there is known an electronic apparatus whose frame includes parts manufactured by molding or by shaping of steel plates. These separate parts have then been attached to each other in order to obtain the load bearing frame of the electronic apparatus.

In order to provide the electronic components within the electronic apparatus with adequate cooling, cooling elements have been provided at the components which generate significant amounts of heat. To accomplish this, suitable pipes and fluid connectors have been arranged in the electric components space of the apparatus in order to accomplish the necessary cooling fluid circulation.

The previously known electronic apparatus therefore consists of many separate parts attached to each other, which is not a reliable nor suitable solution for all implementations.

### SUMMARY OF THE INVENTION

In an embodiment of the invention, an object is to solve the above-mentioned drawback and to provide an electronic apparatus with a novel and more reliable structure. This object is achieved with the electronic apparatus according to independent claim 1.

The use of an extruded metallic frame with walls integrated in the metallic frame makes it possible to obtain a robust and rigid apparatus suitable for use also in demanding environments. In such a solution- a flow channel for a cooling fluid can be provided in at least one of the walls during extrusion. This makes it possible to utilize the frame as a cooling device, and the need for fluid connectors within the electronic apparatus can be minimized.

Preferred embodiments of the invention are disclosed in the dependent claims.

### BRIEF DESCRIPTION OF DRAWINGS

In the following, the present invention will be described in closer detail by way of example and with reference to the attached drawings, in which

Figures 1 to 3 illustrate alternative ways of shaping a frame.

Figures 4 and 5 illustrate fluid channels,

Figures 6 and 7 illustrate a location of components in an embodiment,

Figures 8 to 10 illustrate detachable covers, and

Figure 11 illustrates an embodiment of an electronic apparatus.

### DESCRIPTION OF AT LEAST ONE EMBODIMENT

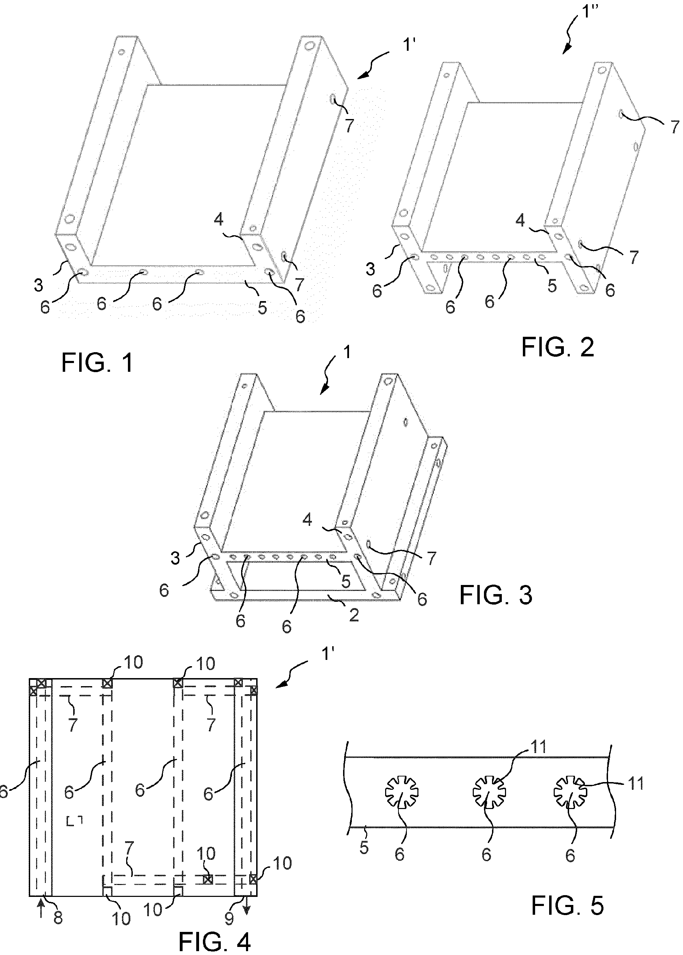

Figures 1 to 3 illustrate alternative ways of shaping a frame for an electronic apparatus. In Figure 1, the frame 1' has a cross section which is generally U shaped, while the cross section of the frame 1" in Figure 2 is generally H shaped. In Figure 3, the cross section of the frame 1 is also generally H shaped, however, an additional bottom wall 2 is included in the embodiment of Figure 3.

Though the shape of the cross sections of the frames 1', 1", and 1"' is different, in each case the frames are extruded metallic frames 1', 1" with walls 2, 3, 4 and 5 that are integrated parts of the extruded metallic frame. Consequently, the walls are fixedly and rigidly attached to each other and capable of carrying the load of components which are to be installed in the electronic apparatus. A material suitable for use in manufacturing the frame is aluminum, for instance.

At least one of the walls is provided with an extruded flow channel for passing a cooling fluid within a respective wall. In the examples of Figures 1 to 3, all of the walls 2, 3, 4 and 5 have such flow channels 6, which makes it possible to utilize these walls 2, 3, 4 and 5 as cooling elements by circulating a cooling fluid within them. By providing additional bores 7 by drilling, for instance, and by plugging the ends of some of the extruded channels 6, a continuous fluid path can be created within the walls 2, 3, 4 and 5 as is illustrated in Figure 4, for instance. Therefore the cooling fluid can be circulated within the frame 1', 1" or 1 of the electronic apparatus from an inlet arranged outside the electronic apparatus to an outlet arranged outside the electronic apparatus, with no need to provide any fluid connectors within the electronic apparatus. This significantly reduces the risk of a leakage within the electronic apparatus.

Figures 4 and 5 illustrate fluid channels in the frame 1' of Figure 1. Figure 4 illustrates the frame 1' as seen from above. The extruded flow channels 6 have been connected to each other at suitable locations via bores 7 which have been drilled into the frame. In order to provide a flow path from an inlet 8 to an outlet 9, the extruded flow channels 6 and bores 7 have been plugged 10 at suitable locations. In this way, the cooling fluid can be efficiently distributed entirely within the frame 1' of the electronic apparatus.

Figure 5 illustrates the cross sectional shape of the extruded flow channels 6 in the frame 1' of Figure 1. Due to manufacture by extrusion, the inner surface of the flow channels 6 is not round as in a drilled bore, but instead the inner surface of the flow channels 6 has longitudinal fins 11 protruding from the walls of the flow channels. This increases the surface area that comes into contact with the fluid in the flow channels 6. Consequently, heat can be more efficiently transferred from the frame 1' to the fluid in the flow channels 6.

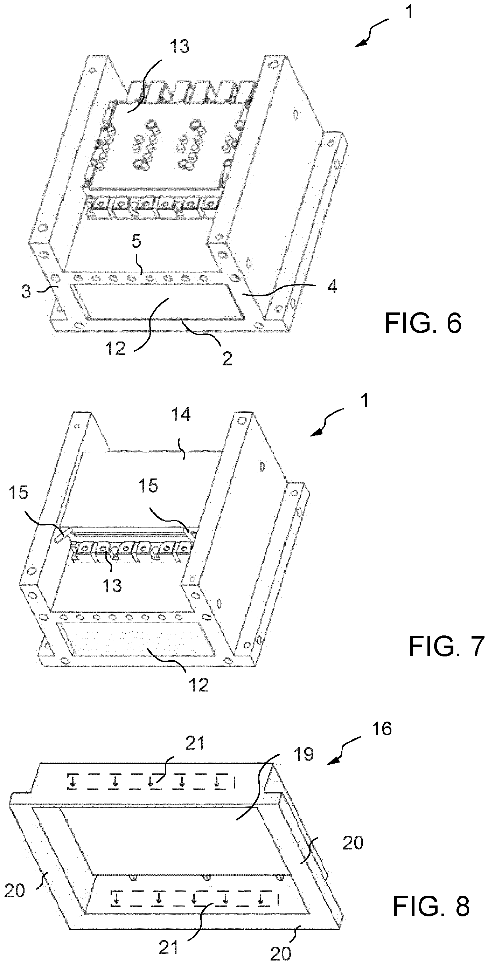

Figures 6 and 7 illustrate the location of components in an embodiment. In the illustrated example, components have been added to an electronic apparatus comprising a frame 1 according to Figure 3. In the following explanation, it is by way of example assumed that the electronic apparatus is a motor drive, such as a frequency converter, which is used for supplying an operating electric power to an electric motor.

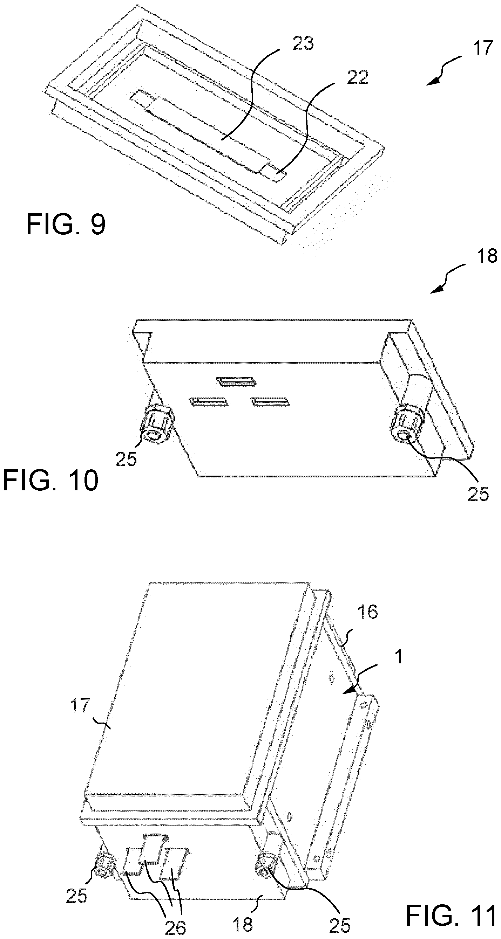

In Figure 6, capacitors 12 have been arranged in a component space which is sealed off by walls 2, 3, 4, 5 and the detachable covers illustrated in Figures 8 and 10. In this location, the capacitors 12 are cooled from four different directions, as the cooling fluid can circulate in all of the walls 2, 3, 4, and 5.

A power semiconductor 13 is arranged on top of the wall 5. If necessary, as illustrated in Figure 7, a separate cooling element 14 may be arranged on top of the power semiconductor 13 in case the cooling provided by the walls 3, 4 and 5 of the frame is not sufficient. In such a case, fluid connectors 15 for passing fluid to a flow channel of the cooling element 14 may be provided in one or more of the surrounding walls 3, 4, and 5.

Figures 8 to 10 illustrate detachable covers 16, 17 and 18 which can be attached to the walls 2, 3, and 4 of the frame 1 for sealing off at least one component space from outside of the electronic apparatus. The covers 16, 17, and 18 may be manufactured from aluminum, for instance.

The cover 16 illustrated in Figure 8 has a recess which is utilized as a mounting space for a circuit board 19 containing electric components. Electric connectors and wires may be utilized for connecting the circuit board 19 to the semiconductor 13 and/or the capacitors 12. Edges 20, which come into contact with the walls 2, 3, and 4, are used for conducting heat from the cover 16 to the walls 2, 3, and 4, and further to the cooling fluid circulating in these walls. In order to enhance cooling of the cover 16 and the circuit board 19, heat pipes 21 or thermosyphons may be integrated into the cover 16 in order to transfer heat from other parts of the cover 16 towards the edges 20, as illustrated by arrows in Figure 8.

In case efficient sealing is required between the cover 16 and the walls 2, 3, and 4, it is possible to provide a groove along the edges 20, for instance, and a sealing ring into this groove. In such a case, the sealing ring may be dimensioned to flatten in the groove during assembly to such an extent that the material of the cover 16 comes into contact with the material of the walls 2, 3 and 4. In this way, heat transfer between the cover 16 and the walls 2, 3, and 4 is not interrupted by the sealing ring.

The cover 17 illustrated in Figure 9 comprises a pressure relief area 22 with a reduced strength in order for the cover 17 to break at the pressure relief area 22 when a pressure inside the electronic apparatus reaches a predetermined limit. Due to this, additional damages may be avoided in case the pressure inside the electronic apparatus suddenly increases significantly due to a damage in the power semiconductor 13, for instance. In case of a cover manufactured of aluminum, for instance, a protective steel plate 23 may be attached at the location of the pressure relief area 22.

Similarly as for the cover 16, the cover 17 may also be used for housing a circuit board (not illustrated). In such a case, it is also possible to arrange electric connectors along the outer edges of the cover 16 in order to facilitate external electrical connections.

The cover 18 illustrated in Figure 10 is provided with fluid connectors 25 via which external piping is connected to the inlet 8 and the outlet 9 of the flow path through the extruded metallic frame 1. With such a solution it is possible to minimize the number of fluid connections that are needed inside the electronic apparatus. In case sufficient cooling is obtained by circulating the cooling fluid completely within walls 2, 3, 4, and 5 of the frame 1 alone, and no additional cooling element is needed, then fluid connectors are not at all needed in the component space or component spaces of the electronic apparatus.

Figure 11 illustrates an embodiment of an electronic apparatus. In Figure 11, the covers 16, 17, and 18 are attached to the frame. At this stage, the fluid connectors 25 and the electric connectors 26 are accessible from the outside of the electronic apparatus, which enables an easy installation. The installation may involve mounting of a protective lid to cover connectors 25 and 26.

It is to be understood that the above description and the accompanying figures are only intended to illustrate the present invention. It will be obvious to a person skilled in the art that the invention can be varied and modified without departing from the scope of the invention.

## Claims

1. An electronic apparatus, **characterized in that** the apparatus comprises:
an extruded metallic frame (1, 1', 1") with walls (2, 3, 4, 5) which are integrated parts of the extruded metallic frame (1, 1', 1"),
at least one extruded flow channel (6) in at least one of the walls (2, 3, 4, 5) for passing a cooling fluid within the respective wall,
an inlet (8) arranged outside the electronic apparatus and an outlet (9) arranged outside the electronic apparatus for providing a flow path via the at least one extruded flow channel (6), and
detachable covers (16, 17, 18) which are attached to the walls (2, 3, 4, 5) for sealing off at least one electric component space from an outside of the electronic apparatus.

2. The electronic apparatus according to claim 1, **characterized in that** at least one of the detachable covers (16) comprises:
an edge (20) which is in contact with the extruded metallic frame (1, 1', 1"), and
an integrated heat pipe (21) or a thermosyphon for transferring heat from other parts of the detachable cover (16) to the edge (20) which is in contact with the extruded metallic frame (1, 1', 1") for transferring heat from the detachable cover (16) to the cooling fluid in the at least one extruded flow channel (9).

3. The electronic apparatus according to claim 1 or 2, **characterized in that** at least one of the detachable covers (17) comprises a pressure relief area (22) with a reduced strength in order for the cover (17) to break at the pressure relief area (22) when a pressure inside the electronic apparatus reaches a predetermined limit.

4. The electronic apparatus according to one of claims 1 to 3, **characterized in that** an inner surface of the at least one extruded flow channel (6) has longitudinal fins (11) protruding from the walls of the flow channel (6) to increase a surface area contacting the cooling fluid in the flow channel.

5. The electronic apparatus according to one of claims 1 to 4, **characterized in that** the flow path for the cooling fluid between the inlet (8) and the outlet (9) is arranged completely within the walls (2, 3, 4, 5) of the extruded metallic frame (1, 1', 1") of the electronic apparatus without passing any fluid via fluid connectors located within the at least one component space of the electronic apparatus.

6. The electronic apparatus according to one of claims 1 to 4, **characterized in that**
a cooling element (14) with a flow channel is arranged in the at least one electric component space, and
the extruded metallic frame (1) with at least one extruded flow channel (6) in at least one wall is provided with connectors (15) within the electronic apparatus for passing fluid to the flow channel of the cooling element (14) and for receiving fluid exiting the flow channel of the cooling element.

7. The electronic apparatus according to one of claims 1 to 6, **characterized in that** the extruded metallic frame (1, 1', 1") has a cross section which is generally H or U shaped.

8. The electronic apparatus according to one of claims 1 to 7, **characterized in that** the electronic apparatus is a motor drive.

## Amended claims

### Amended claims in accordance with Rule 137(2) EPC.

**1.** An electronic apparatus comprising:
a metallic frame (1, 1', 1") with walls (2, 3, 4, 5) which are integrated parts of the metallic frame (1, 1', 1"),
at least one flow channel (6) in at least one of the walls (2, 3, 4, 5) for passing a cooling fluid within the respective wall,
an inlet (8) arranged outside the electronic apparatus and an outlet (9) arranged outside the electronic apparatus for providing a flow path via the at least one flow channel (6), and
detachable covers (16, 17, 18) which are attached to the walls (2, 3, 4, 5) for sealing off at least one electric component space from an outside of the electronic apparatus, **characterized in that**:
the metallic frame (1, 1', 1") is an extruded metallic frame and the at least one flow channel (6) is a flow channel extruded in the at least one wall, and
at least one of the detachable covers (16) comprises:
an edge (20) which is in contact with the extruded metallic frame (1, 1', 1"), and
an integrated heat pipe (21) or a thermosyphon for transferring heat from other parts of the detachable cover (16) to the edge (20) which is in contact with the extruded metallic frame (1, 1', 1") for transferring heat from the detachable cover (16) to the cooling fluid in the at least one extruded flow channel (9).

**2.** The electronic apparatus according to claim 1, **characterized in that** at least one of the detachable covers (17) comprises a pressure relief area (22) with a reduced strength in order for the cover (17) to break at the pressure relief area (22) when a pressure inside the electronic apparatus reaches a predetermined limit.

**3.** The electronic apparatus according to one of claims 1 to 2, **characterized in that** an inner surface of the at least one extruded flow channel (6) has longitudinal fins (11) protruding from the walls of the flow channel (6) to increase a surface area contacting the cooling fluid in the flow channel.

**4.** The electronic apparatus according to one of claims 1 to 3, **characterized in that** the flow path for the cooling fluid between the inlet (8) and the outlet (9) is arranged completely within the walls (2, 3, 4, 5) of the extruded metallic frame (1, 1', 1") of the electronic apparatus without passing any fluid via fluid connectors located within the at least one component space of the electronic apparatus.

**5.** The electronic apparatus according to one of claims 1 to 3, **characterized in that**
a cooling element (14) with a flow channel is arranged in the at least one electric component space, and
the extruded metallic frame (1) with at least one extruded flow channel (6) in at least one wall is provided with connectors (15) within the electronic apparatus for passing fluid to the flow channel of the cooling element (14) and for receiving fluid exiting the flow channel of the cooling element.

**6.** The electronic apparatus according to one of claims 1 to 5, **characterized in that** the extruded metallic frame (1, 1', 1") has a cross section which is generally H or U shaped.

**7.** The electronic apparatus according to one of claims 1 to 6, **characterized in that** the electronic apparatus is a motor drive.
